# EUROPÄISCHE PATENTSCHRIFT

(11) **EP 4 128 336 B1**
(45) Veröffentlichungstag und Bekanntmachung des Hinweises auf die Patenterteilung: **01.05.2024**
(21) Anmeldenummer: 21746477.5
(22) Anmeldetag: 20.07.2021
(51) Int. Cl.: H01L 23/373

(54) **LEISTUNGSMODUL UND VERFAHREN ZUR HERSTELLUNG EINES LEISTUNGSMODULS**
POWER MODULE AND METHOD FOR PRODUCING A POWER MODULE
MODULE DE PUISSANCE ET PROCÉDÉ DE FABRICATION D'UN MODULE DE PUISSANCE

(30) Priorität: 21.07.2020 DE 102020119209
(43) Veröffentlichungstag der Anmeldung: 08.02.2023
(73) Patentinhaber: Rogers Germany GmbH, 92676 Eschenbach (DE)
(72) Erfinder: WAGLE, Fabian, 95447 Bayreuth (DE); MEYER, Andreas, 95469 Speichersdorf (DE); POLSTER, Sebastian, 93049 Regensburg (DE)
(74) Vertreter: Müller Schupfner & Partner Patent- und Rechtsanwaltspartnerschaft mbB
(86) Internationale Anmeldenummer: PCT/EP2021/070219
(87) Internationale Veröffentlichungsnummer: WO 2022/018063

(56) Entgegenhaltungen:
- EP-A2- 1 523 037
- DE-A1- 3 941 814
- DE-A1- 4 208 604

## Beschreibung

Die vorliegende Erfindung betrifft ein Leistungsmodul und ein Verfahren zur Herstellung eines Leistungsmoduls.

Leistungsmodule für elektrische Bauteile sind hinlänglich bekannt. Dabei werden bevorzugt Metall-Keramik-Substrate als Leiterplatten verwendet. Metall-Keramik-Substrate sind beispielsweise als Leiterplatten oder Platinen aus dem Stand der Technik hinlänglich bekannt, beispielsweise aus der DE 10 2013 104 739 A1, der DE 19 927 046 B4, DE 39 41 814 A1, DE 42 08 604 A1, EP1 523 037 A2 und der DE 10 2009 033 029 A1. Typischerweise werden auf einer Bauteilseite des Metall-Keramik-Substrats Anschlussflächen für elektrische Bauteile und Leiterbahnen angeordnet, wobei die elektrischen Bauteile und die Leiterbahnen zu elektrischen Schaltkreisen zusammenschaltbar sind. Wesentliche Bestandteile der Metall-Keramik-Substrate sind eine Isolationsschicht, die bevorzugt aus einer Keramik gefertigt ist, und wenigstens eine an die Isolationsschicht angebundene Metallschicht. Wegen ihrer vergleichsweise hohen Isolationsfestigkeiten haben sich aus Keramik gefertigte Isolationsschichten in der Leistungselektronik als besonders vorteilhaft erwiesen. Durch eine Strukturierung der Metallschicht können sodann Leiterbahnen und/oder Anschlussflächen für die elektrischen Bauteile realisiert werden.

Aus der DE 11 2015 007 169 T5, der US 2020 0 194 329 A1 und der JP 11 265 976 A1 sind jeweils Kühlkörper bekannt, auf dem zwei Metall-Keramik-Substrate angeordnet sind. Dabei steht das Keramikelement gegenüber den Metallschichten an Vorder- und Rückseite vor.

Voraussetzung für das Bereitstellen eines solchen Metall-Keramik-Substrats ist eine dauerhafte Anbindung der Metallschicht an die Keramikschicht. Neben einem sogenannten Direktanbindungsverfahren, d. h. einem DCB- oder DAB-Verfahren, ist es aus dem Stand der Technik bekannt, die Metallschicht über ein Lotmaterial an die Keramikschicht anzubinden.

Aufgrund der unterschiedlichen thermischen Ausdehnungskoeffizienten des Metalls in der Metallschicht auf der einen Seite und der Keramik in der Keramikschicht auf der anderen Seite ergeben sich regelmäßig thermomechanische Spannungen, die sogar zu einem Verbiegen des Metall-Keramik-Substrats führen können.

Ausgehend vom Stand der Technik macht es sich die vorliegende Erfindung zur Aufgabe, Leistungsmodule bereitzustellen, bei denen eine Neigung zum Verbiegen der Leistungsmodule bzw. der Metall-Keramik-Substrate reduziert ist.

Diese Aufgabe wird durch ein Leistungsmodul gemäß Anspruch 1 und ein Verfahren zur Herstellung eines Leistungsmoduls gemäß Anspruch 11 gelöst. Weitere Vorteile und Eigenschaften ergeben sich aus den Unteransprüchen sowie der Beschreibung und den beigefügten Figuren.

Gemäß einem ersten Aspekt der vorliegenden Erfindung ist ein Leistungsmodul für elektrische Bauteile vorgesehen, umfassend:
- eine Keramiklage, eine primäre Metalllage und eine sekundäre Metalllage, wobei die primäre Metalllage und die sekundäre Metalllage an der Keramiklage an gegenüberliegenden Seiten angeordnet sind,
wobei die Keramiklage einen ersten Keramikabschnitt und einen vom ersten Keramikabschnitt durch eine Unterbrechung beabstandeten zweiten Keramikabschnitt aufweist, und wobei unterhalb und oberhalb der als Dehnungsfuge dienenden Unterbrechung ein metallfreier Bereich ausgebildet ist.

Gegenüber den aus dem Stand der Technik bekannten Leistungsmodulen ist es erfindungsgemäß vorgesehen, dass sowohl unterhalb als auch oberhalb der als Dehnungsfuge dienenden Unterbrechung ein metallfreier Bereich ausgebildet ist. Dadurch ist es in vorteilhafter Weise möglich, einer Durchbiegung des Leistungsmoduls jedenfalls der Keramiklage entgegenzuwirken. Ein weiterer Vorteil ist, dass durch den metallfreien Bereich unterhalb der Dehnungsfuge Metallabschnitte an der Oberseite der Keramiklage, d. h. Teile der primären Metalllage, näher an die Unterbrechung herangeführt werden können, ohne dass Gefahr besteht, dass im Betrieb ein elektrischer Überschlag zwischen der primären Metalllage und der sekundären Metalllage erfolgt. Dies wirkt sich auch positiv auf das bauraumökonomische Ausnutzen der Oberseite der Keramiklage aus, da dadurch erhöhte Leiterbahndichten bzw. Dichten an Anschlüssen auf einer Bauteilseite des Leistungsmoduls realisiert werden können.

Insbesondere ist unter einer Unterbrechung, die als Dehnungsfuge dient, zu verstehen, dass es sich bei der Unterbrechung nicht um eine Aussparung handelt, die beispielsweise im Rahmen einer Durchkontaktierung vorgenommen wird. Vielmehr ist es vorgesehen, dass mittels der Unterbrechung eine vollständige Separation und Trennung einzelner Keramikabschnitte, d. h. insbesondere des ersten vom zweiten Keramikabschnitt, vorgesehen ist. Weiterhin ist es bevorzugt vorgesehen, dass die sekundäre Metalllage als Rückseitenmetallisierung und/oder Kühlstruktur ausgebildet ist, während die primäre Metalllage eine Bauteilmetallisierung darstellt. Unter einer Bauteilmetallisierung ist insbesondere die Metallisierung zu verstehen, die auf der Bauteilseite des Metall-Keramik-Substrats ausgebildet ist. Der Begriff Bauteilmetallisierung ist damit nicht auf solche Metallisierungen beschränkt, an denen tatsächlich ein Bauteil angebunden ist, sondern bezeichnet im Allgemeinen die Metallisierung an der gesamten Seite, die mehrere Strukturierung zur Ausbildung von Leiterbahnen und Anschlussflächen bereitstellt.

Insbesondere ist es vorgesehen, dass die erste Metalllage und/oder die zweite Metalllage einstückig ausgebildet sind. Unter "einstückig" ist hier insbesondere eine Ausbildung der ersten und/oder zweiten Metalllage gemeint, bei der keine zwei verschiedenen Metalllagen miteinander verbunden werden bzw. insbesondere keine Rückseitenmetallisierung an einen Kühlkörper angebunden wird. Insbesondere ist die sekundäre bzw. zweite Metalllage direkt an die Keramiklage angebunden und ist bevorzugt Teil der Kühlstruktur.

Weiterhin ist es vorgesehen, dass die erste bzw. primäre Metalllage und/oder die zweite bzw. sekundäre Metalllage strukturiert ist, insbesondere unter Ausbildung eines ersten Metallabschnitts und eines zweiten Metallabschnitts. Dabei können der erste Metallabschnitt und der zweite Metallabschnitt im gefertigten Metall-Keramik-Substrat miteinander verbunden sein.

Vorzugsweise ist es vorgesehen, dass die primäre Metalllage und die sekundäre Metalllage im Wesentlichen gleich dick sind. Mit anderen Worten: eine Dicke der primären Metalllage entspricht im Wesentlichen einer Dicke der sekundären Metalllage, gemessen in einer Richtung parallel zur Stapelrichtung. "Im Wesentlichen" umfasst dabei Abweichungen der absoluten Zahlenwerten von weniger als +/- 15 %, bevorzugt weniger als +/- 10 % und besonders bevorzugt weniger als +/- 5 %. Dadurch wird mit Vorteil eine im Wesentlichen symmetrische Materialverteilung an der Oberseite und/oder Unterseite der Keramiklage ermöglicht, was sich positiv auf die Biegeeigenschaften des gefertigten Metall-Keramik-Substrats auswirkt. Insbesondere wird durch die Symmetrie ein gegenseitiges Kompensieren der auftretenden Biegekräfte, veranlasst durch die unterschiedlichen thermischen Ausdehnungskoeffizienten, unterstützt.

Hierzu ist es bevorzugt vorgesehen, dass die primäre Metalllage, die sekundäre Metalllage und die Keramiklage bezüglich Materialwahl und Dicke derart ausgelegt sind, dass sich bezüglich der thermomechanischen Ausdehnungseigenschaften ein symmetrisches Leistungsmodul ausgebildet wird. Dies wird beispielsweise durch Metallschichten aus demselben Metall mit im Wesentlichen selber Dicke realisiert. Es kann aber auch sein, dass unterschiedliche Metalle für die primäre Metalllage und die sekundäre Metalllage herangezogen werden. Um eine symmetrische Auslegung der thermomechanischen Ausdehnungseigenschaften zu erzielen, müssen dann die primäre und die sekundäre Metalllage unterschiedlich dick sein, um die entsprechend unterschiedliche Materialwahl für eine symmetrische Verteilung der thermischen Ausdehnungskoeffizienten zu kompensieren. Die symmetrische Verteilung bezieht sich dabei auf eine parallel zur Stapelrichtung verlaufende Richtung. Im Falle einer sekundären Metalllage, die bereits Teil der Kühlstruktur ist, wird dabei eine effektive Dicke der Kühlstruktur bzw. der sekundären Metalllage angenommen. Die effektive Dicke berücksichtigt, dass bei einer Kühlstruktur mit Kühlfinnen das Material anders als bei einer Kühlstruktur ohne Finnen verteilt ist. Dabei wird als effektive Dicke diejenige Dicke angenommen, die sich ergibt, wenn man mit demselben Material der Kühlstruktur mit Finnen einen Kühlkörper realisieren würde, der keine Finnen aufweist und als Block ausgebildet ist. Die effektive Dicke ist somit größer als die Dicke des Bereichs des Kühlkörpers von dem die Finnen abstehen.

Weiterhin ist es besonders bevorzugt, wenn die Anbindungsflächen zwischen der Keramiklage und der primären Metalllage einerseits und die Anbindungsfläche zwischen der Keramiklage und der sekundären Metalllage in Stapelrichtung gesehen im Wesentlichen zueinander deckungsgleich angeordnet sind. Insbesondere ist es vorgesehen, dass mehr als 50 %, bevorzugt mehr als 70 % und besonders bevorzugt mehr als 85 % aller Anbindungsfläche auf der Bauteilseite, d. h. von der Keramiklage zur primären Metalllage, deckungsgleich zu den Anbindungsflächen auf der Seite der Rückseitenmetallisierung, d. h. von der Keramiklage zur sekundären Metalllage, angeordnet sind. Insbesondere verlaufen die Rücksprünge in der sekundären Metalllage und Freibereiche zwischen einem ersten Metallabschnitt und einem zweiten Metallabschnitt in der primären Metalllage deckungsgleich, bevorzugt in Bereichen mit Unterbrechungen in der Keramiklage und bevorzugt zumindest bereichsweise in Bereichen ohne Unterbrechung in der Keramiklage. Mit anderen Worten: Bevorzugt ist es vorgesehen, dass Rücksprünge bzw. metallfreie Bereich auf der Seite der sekundären Metalllage im Wesentlichen deckungsgleich zu Isolationsgräben in der primären Metalllage verlaufen.

Als Materialien für die primäre Metalllage und/oder die sekundäre Metalllage im Leistungsmodul, sind Kupfer, Aluminium, Molybdän und/oder deren Legierungen, sowie Laminate wie CuW, CuMo, CuAI, AlCu und/oder CuCu vorstellbar, insbesondere eine Kupfer-Sandwichstruktur mit einer ersten Kupferschicht und einer zweiten Kupferschicht, wobei sich eine Korngröße in der ersten Kupferschicht von der Korngröße in einer zweiten Kupferschicht unterscheidet. Weiterhin ist bevorzugt vorgesehen, dass die primäre Metalllage, insbesondere als Bauteilmetallisierung, oberflächenmodifiziert ist. Als Oberflächenmodifikation ist beispielsweise eine Versiegelung mit einem Edelmetall, insbesondere Silber und/oder Gold, oder EN IG ("*electroless nickel immersion gold*")*,* Nickel oder ein Kantenverguss an der ersten bzw. zweiten Metallisierungsschicht zur Unterdrückung einer Rissbildung bzw. -weitung denkbar.

Vorzugsweise weist Keramiklage Al₂O₃, Si₃N₄, AlN, eine HPSX-Keramik (d. h. eine Keramik mit einer Al₂O₃- Matrix, die einen x-prozentigen Anteil an ZrO₂ umfasst, beispielsweise Al₂O₃ mit 9% ZrO₂ = HPS9 oder Al₂O₃ mit 25% ZrO₂ = HPS25), SiC, BeO, MgO, hochdichtes MgO (> 90% der theoretischen Dichte), TSZ (tetragonal stabilisiertes Zirkonoxid) oder ZTA als Material für die Keramik auf. Es ist dabei auch vorstellbar, dass die Keramiklage als Verbund- bzw. Hybridkeramik ausgebildet ist, bei der zur Kombination verschiedener gewünschter Eigenschaften mehrere Keramikschichten, die sich jeweils in Hinblick auf ihre materielle Zusammensetzung unterscheiden, übereinander angeordnet und zu einer Isolationsschicht zusammengefügt sind. Denkbar ist auch, dass zwischen zwei Keramikschichten eine metallische Zwischenschicht angeordnet ist, die vorzugsweise dicker als 1,5 mm und/oder dicker als die zwei Keramikschichten in Summe ist. Vorzugsweise wird eine möglichst wärmeleitfähige Keramik für einen möglichst geringen Wärmewiderstand verwendet.

Gemäß einer bevorzugten Ausführungsform ist es vorgesehen, dass die primäre Metalllage und/oder die sekundäre Metalllage auf einer der Unterbrechung zugewandten Seite einen Rücksprung aufweist. Insbesondere ist es dadurch in vorteilhafter Weise möglich, einen metallfreien Bereich unterhalb der Keramiklage zu erzeugen, der sich insbesondere zumindest teilweise auch in Richtung der Haupterstreckung unterhalb der Keramiklage fortsetzt. Dadurch wird ein ausreichend metallfreier Bereich bereitgestellt, der zum einen eine Neigung zur Biegung reduziert und gleichzeitig auch die Gefahr eines elektrischen Überschlags mindert. Hierbei ist es insbesondere von Vorteil, vor dem Verbinden der Keramiklage mit der primären und/oder sekundären Metalllage zur Ausbildung des späteren Rücksprungs eine Strukturierung an der Außenseite der primären Metalllage und/oder sekundären Metalllage vorzunehmen. Dabei ist es insbesondere vorgesehen, dass die Lage des Rücksprungs abgestimmt ist mit der Lage der Unterbrechung in der Keramiklage. Weiterhin ist es denkbar, dass die im gefertigten Zustand als Bauteilmetallisierung dienende primäre Metalllage mit Rücksprüngen versehen wird, um entsprechende Leiterbrücken zu erzeugen, die sich oberhalb der Unterbrechung erstrecken und beispielsweise den ersten Keramikabschnitt mit dem zweiten Keramikabschnitt elektrisch leitend verbinden.

Vorzugsweise ist es vorgesehen, dass eine parallel zu einer Haupterstreckungsebene bemessene erste Länge der Unterbrechung zwischen dem ersten Keramikabschnitt und dem zweiten Keramikabschnitt einen Wert annimmt, der kleiner als 300 µm, bevorzugt kleiner als 200 µm und besonders bevorzugt kleiner als 100 µm ist. Vorzugsweise nimmt die erste Länge einen Wert zwischen1 µm und 250 µm, bevorzugt zwischen 20 µm und 150 µm und bevorzugt zwischen 20 µm und 100 µm an. Damit betrifft der Gegenstand insbesondere solche Leistungsmodule, bei denen die Keramikabschnitte vergleichsweise nah zueinander angeordnet sind. Es handelt sich somit nicht um ein Leistungsmodul, bei dem lediglich einzelne Metall-Keramik-Substrate an einen gemeinsamen Kühlkörper angebunden sind.

Der metallfreie Bereich ist bevorzugt unterhalb der Dehnungsfuge in die sekundäre Metalllage, insbesondere unmittelbar an die Keramiklage angebundene sekundäre Metalllage, eingelassen. Vorstellbar ist auch, dass zusätzlich zu der zweiten bzw. sekundären Metalllage ein Kühlkörper vorgesehen ist. Damit unterscheidet sich der Gegenstand von Leistungsmodulen bei den einzelne Metall-Keramik-Substrate auf einem Kühlkörper angeordnet werden.

Weiterhin ist es bevorzugt vorgesehen, dass ein Verhältnis einer parallel zu einer Haupterstreckungsebene bemessenen ersten Länge der Unterbrechung zwischen dem ersten Keramikabschnitt und dem zweiten Keramikabschnitt zu einer parallel dazu gemessenen zweiten Länge des metallfreien Bereichs, insbesondere des Rücksprungs, insbesondere unter- und/oder oberhalb der Unterbrechung, einen Wert zwischen 0,005 und 1, bevorzugt zwischen 0,01 und 0,5 und besonders bevorzugt zwischen 0,02 und 0,2 annimmt. Dadurch wird in vorteilhafter Weise sichergestellt, dass sich der metallfreie Bereich auch ausreichend weit unterhalb der Keramiklage erstreckt, um so die vorteilhafte Wirkung in Bezug auf die Biegung des Leistungsmoduls und die Meidung eines elektrischen Überschlags auszubilden.

Beispielsweise nimmt dabei eine erste Länge einen Wert zwischen 10 µm und 1500 µm, bevorzugt zwischen 15 µm und 800 µm und besonders bevorzugt zwischen 20 und 60 µm an. Dabei kann beispielsweise der Wert für die erste Länge abhängen von der Herstellungsart der Unterbrechung in der Keramiklage. Beispielsweise ist es mittels Lasern möglich, erste Längen zwischen 10 und 80 µm zu realisieren, während mittels einer Säge erste Längen von 200 bis 1000 sinnvoll möglich sind. Eine erste Länge von wenigen Mikrometern ist durch ein gezieltes Platzieren einzelner Metallabschnitte möglich.

Beispielsweise nimmt dabei eine zweite Länge einen Wert zwischen 20 µm und 2000 µm, bevorzugt zwischen 100 µm und 1600 µm und besonders bevorzugt zwischen 200 und 1000 µm an.

Ferner weist der metallfreie Bereich unterhalb der Unterbrechung, d. h. auf der der sekundären Metalllage zugewandten Seite, eine Tiefe auf, die einen Wert zwischen 50 µm und 600 µm, bevorzugt zwischen 80 µm und 500 µm und besonders bevorzugt zwischen 200 µm und 400 µm annimmt.

Vorzugsweise ist der metallfreie Bereich unterhalb der Unterbrechung derart gestaltet, dass er einen rechteckigen, runden oder dreieckigen Querschnitt in einer senkrecht zur Haupterstreckungsebene verlaufenden Ebene aufweist. Dadurch ist es in vorteilhafter Weise möglich, die Geometrie des metallfreien Bereichs, insbesondere des Rücksprungs, an den jeweiligen Anwendungsfall optimal anzupassen. Beispielsweise erweist es sich als vorteilhaft, wenn der Rücksprung durch einen Prägevorgang erzeugt wird und dabei beispielsweise ein dreieckiger Querschnitt ausgebildet wird. In entsprechender Weise kann man auch das Fertigungsverfahren optimieren, indem die jeweilige Geometrie des metallfreien Bereichs vorteilhaft für eine möglichst einfache Ausbildung des Rücksprungs angepasst wird.

Weiterhin ist es besonders bevorzugt vorgesehen, dass die Unterbrechung mit einem nicht-leitenden Material verfüllt ist und/oder das Leistungsmodul zumindest teilweise verkapselt ist. Vorzugsweise ist es sogar vorgesehen, dass der Rücksprung, der unterhalb der Keramiklage, insbesondere zwischen der sekundären Metalllage und der Keramiklage angeordnet ist, mit dem nicht-leitenden Material verfüllt wird. Beispielsweise handelt es sich bei dem nicht-leitenden Material um einen Kunststoff, der insbesondere nicht-leitend ist und eine Elastizität aufweist, die sich vorteilhaft auswirkt auf die Reduktion der Biegung des Leistungsmoduls. Es ist auch vorstellbar, dass das nicht-leitende Material derart ausgesucht wird, dass das nicht-leitende Material der andernfalls vorliegenden Biegung entgegenwirkt und diese gegebenenfalls sogar kompensiert. Weiterhin ist es bevorzugt vorgesehen, wenn das nicht-leitende Material, beispielsweise durch einen Zusatz von Keramikteilchen oder einem Keramikpulver, eine besonders hohe Isolationsfestigkeit aufweist. Beispielsweise wird in einem Kunststoff hierzu Keramikmaterial bzw. Keramikpulver und/oder Glasmaterial bzw. Glaspulver eingelassen, wodurch die Isolationsfestigkeit des nicht-leitenden Materials erhöht wird. Denkbar ist auch, dass ein Verfüllen der Unterbrechung einer Rissbildung entgegenwirkt, insbesondere in den Grenzbereichen zwischen der primären Metalllage und der Keramiklage bzw. der sekundären Metalllage und der Keramiklage.

Vorzugsweise ist es vorgesehen, dass die Keramiklage eine Dicke aufweist, die kleiner als 250 µm, bevorzugt kleiner als 200 µm und besonders bevorzugt kleiner als 150 µm ist. Somit handelt es sich um vergleichsweise dünne Keramiklagen, die sich insbesondere im Fertigungsverfahren auf Grund ihrer reduzierten Dicke leicht auftrennen lassen. Gleichzeitig erweist sich die Ausbildung von Dehnungsfugen gerade bei solch dünnen Keramiklagen als vorteilhaft, da diese dünnen Keramiklagen eine geringere Widerstandskraft gegenüber mechanischen Spannungen aufweisen und somit andernfalls anfälliger wären für ein Brechen im Betrieb.

Vorzugsweise sind mehrere Dehnungsfugen vorgesehen. Insbesondere ist ein Abstand zwischen zwei Dehnungsfugen geringer als 10 mm, bevorzugt kleiner als 5 mm und besonders bevorzugt kleiner als 2,5 mm. Insbesondere trifft dies zu auf den Mittelwert aller Abstände zwischen Dehnungsfugen. Es ist auch vorstellbar, dass sich mindestens zwei der mehreren Dehnungsfugen kreuzen. Die mehreren Dehnungsfugen bilden bevorzugt ein Muster aus. Dadurch werden vergleichsweise gering dimensionierte Keramikabschnitte und eine Vielzahl an voneinander aufgetrennten Keramikabschnitten realisiert, die weniger anfällig sind für mechanischen Spannungen. Insbesondere ist im Leistungsmodul ein Netz an Dehnungsfugen ausgebildet. Mit anderen Worten: Es gibt mehrere sich insbesondere kreuzende Dehnungsfugen. Beispielsweise verursachen die Dehnungsfugen eine schachbrettähnliche Anordnung von mehreren ersten Keramikabschnitten und zweiten Keramikabschnitten. Dabei müssen die Dehnungsfugen, die sich schneiden, nicht senkrecht zueinander verlaufen. Bevorzugt sind mindestens zwei parallel zueinander verlaufenden Dehnungsfugen vorgesehen. Weiterhin ist es bevorzugt, dass es mindestens 5, bevorzugt 10 erste und 5, bevorzugt 10 zweite Keramikabschnitte im Leistungsmodul gibt, die durch eine Dehnungsfuge voneinander getrennt sind. Vorzugsweise ist es vorgesehen, dass für den ersten Keramikabschnitt und/oder zweiten Keramikabschnitt eine Maximalanzahl an Bauteilen vorgesehen ist. Beispielsweise ist die Maximalzahl 5, bevorzugt 3 und besonders bevorzugt 2. Dadurch lässt sich die Wärmeentwicklung pro Keramikabschnitt möglichst gering halten.

Ein weiterer Gegenstand der vorliegenden Erfindung ist ein Verfahren zur Herstellung eines Leistungsmoduls, umfassend:
- Bereitstellen einer Keramiklage, einer primären Metalllage und/oder einer sekundären Metalllage,
- Anbinden der primären Metalllage und/oder der sekundären Metalllage an die Keramiklage,
wobei zur Ausbildung einer Unterbrechung in der Keramiklage die Keramiklage
- nach dem Anbinden aufgetrennt wird, beispielsweise mittels Laserlicht, Ätzen, Fräsen oder einem Wasserstrahl, oder
- zum Anbinden an die primären Metalllage und/oder sekundären Metalllage als erster Keramikabschnitt und zweiter Keramikabschnitt vereinzelt bereitgestellt wird.

Alle für das Leistungsmodul beschriebenen Eigenschaften und Vorteile lassen sich analog anwenden auf das Verfahren und andersrum. Insbesondere hat es sich als besonders vorteilhaft erwiesen durch die genannten Trennmethoden eine Unterbrechung zu realisieren, die als Dehnungsfuge zwischen dem ersten Keramikabschnitt und dem zweiten Keramikabschnitt dienen kann, wodurch mit Vorteil einer Biegung entgegengewirkt werden kann, die üblicherweise in einem Leistungsmodul mit einer einzigen, insbesondere durchgehenden, Keramiklage zu erwarten wäre.

Weiterhin ist es vorgesehen, dass die primäre Metalllage oder die sekundäre Metalllage vor dem Anbinden an einer Seite, die im fertigen Zustand der Unterbrechung zugewandt ist, mit mindestens einem Rücksprung versehen wird, vorzugsweise unter Verwendung eines mechanischen Werkzeugs und/oder eines Lasers und/oder durch Ätzen. Durch eine entsprechende Ausbildung eines Rücksprungs kann eine Unterbrechung unterhalb der Keramiklage hergestellt werden, die sich insbesondere als besonders vorteilhaft erwiesen hat, um Biegungen entgegenzuwirken.

Weiterhin ist es bevorzugt vorgesehen, dass
- ein erster Verbund aus einem ersten Keramikabschnitt und einem ersten Metallabschnitt der primären Metalllage und einem ersten Metallabschnitt der sekundären Metalllage und
- ein zweiter Verbund aus einem zweiten Keramikabschnitt und einem zweiten Metallabschnitt der primären Metalllage und einem zweiten Metallabschnitt der sekundären Metalllage
gebildet wird, wobei der erste Verbund und der zweite Verbund, insbesondere der erste Metallabschnitt und der zweite Metallabschnitt der sekundären Metalllage in einer Fixiermasse und/oder einem Fixierelement, vorzugsweise unter Verwendung eines Pick-and-Place Roboters, fixiert werden.

Dadurch ist es in vorteilhafter Weise möglich, eine Separation des ersten Verbunds vom zweiten Verbund vorzunehmen, wodurch im gesamten Leistungsmodul einem Durchbiegen entgegengewirkt wird, weil sich die mechanische Spannungen nicht über die gesamte Quererstreckung des Leistungsmoduls entwickeln können bzw. ausbilden können. Insbesondere die Verwendung eines Pick-and-Place Roboters gestattet die reproduzierbare und möglichst genaue Positionierung des einzelnen ersten Verbunds und/oder zweiten Verbunds. Bei der Fixiermasse handelt es sich beispielsweise um ein thermoplastisches Material, ein Acrylmaterial, beispielsweise Acrylglas (PMMA) und/oder einen wasserlöslichen Kunststoff. Beispielsweise sind auch Alginate denkbar.

Insbesondere ist es vorgesehen, dass die Fixiermasse derart ausgelegt ist, dass sie während eines Platziervorgangs ein einfaches Einsetzen des ersten Verbunds und des zweiten Verbunds in die Fixiermasse zulässt, während nach einem Aushärten beispielsweise der erste Verbund und der zweite Verbund fixiert sind in der Fixiermasse. Nach einem anschließenden Verkapseln ist es vorstellbar, dass die Fixiermasse wieder vom ersten Verbund und dem zweiten Verbund gelöst wird, insbesondere indem eine lösliche Fixiermasse verwendet wird, die einer Flüssigkeit, insbesondere Wasser, ausgesetzt wird, um eine Abtrennung der Fixiermasse vom ersten Verbund und dem zweiten Verbund zu ermöglichen. Beispielsweise handelt es sich bei der Fixiermasse um eine solche Masse, die beispielsweise aus der Dentaltechnik bekannt ist und zur Aufnahme von Zahn- und/oder Kieferabdrücken vorgesehen ist.

Weiterhin ist es besonders vorzugsweise vorgesehen, dass eine Verkapselung des Leistungsmoduls vorgenommen wird. Dadurch ist es möglich, den ersten Verbund und den zweiten Verbund voneinander dauerhaft positionsgenau zu fixieren, beispielsweise mit dem Fixierelement und/oder der Fixiermasse, und gleichzeitig die elektrischen Bauteile und die elektrische Verbindung vor äußeren Einflüssen zu schützen. Hierzu ist es insbesondere vorgesehen, dass vor einer Verkapselung der erste Verbund oder der zweite Verbund mit elektrischen Verbindungen und/oder elektrischen Bauteilen bestückt werden. Weiterhin ist es bevorzugt vorgesehen, dass zumindest die primäre Metalllage eine entsprechende Strukturierung erfährt, um Metallabschnitte oder Leitungsbahnen zu bilden, die ein Anschließen von Bauteilen gestattet bzw. die Verbindung der einzelnen Bauteile untereinander. Beispielsweise ist es besonders bevorzugt vorgesehen, dass die Fixiermasse und/oder das Fixierelement nach der Fertigung der Verkapselung ersetzt wird durch eine entsprechende Kühlflüssigkeitsführung, die die Kühlfinnen bzw. die Kühlstruktur der sekundären Metalllage mit einem Kühlfluid versorgt, um für einen entsprechenden Abtransport der Wärme zu sorgen.

Weiterhin ist es besonders bevorzugt vorgesehen, dass die primäre Metalllage und/oder die sekundäre Metalllage über ein Direktanbindungsverfahren, ein heißisostatische Pressen oder über ein Aktivlötverfahren an die Keramiklage angebunden werden.

Unter einem "DCB-Verfahren" (Direct-Copper-Bond-Technology) oder einem "DAB-Verfahren" (Direct-Aluminium-Bond-Technology) versteht der Fachmann ein solches Verfahren, das beispielsweise zum Verbinden von Metallabschnitten oder -blechen (z. B. Kupferblechen oder -folien oder Aluminiumblechen oder -folien) miteinander und/oder mit Keramik oder Keramikschichten dient, und zwar unter Verwendung von Metall- bzw. Kupferblechen oder Metall- bzw. Kupferfolien, die an ihren Oberflächenseiten eine Schicht oder einen Überzug (Aufschmelzschicht), aufweisen. Bei diesem beispielsweise in der US 3 744 120 A oder in der DE23 19 854 C2 beschriebenen Verfahren bildet diese Schicht oder dieser Überzug (Aufschmelzschicht) ein Eutektikum mit einer Schmelztemperatur unter der Schmelztemperatur des Metalls (z. B. Kupfers), so dass durch Auflegen der Folie auf die Keramik und durch Erhitzen sämtlicher Schichten diese miteinander verbunden werden können, und zwar durch Aufschmelzen des Metalls bzw. Kupfers im Wesentlichen nur im Bereich der Aufschmelzschicht bzw. Oxidschicht.

Insbesondere weist das DCB-Verfahren dann z. B. folgende Verfahrensschritte auf:
- Oxidieren einer Kupferfolie derart, dass sich eine gleichmäßige Kupferoxidschicht ergibt;
- Auflegen des Kupferfolie auf die Keramikschicht;
- Erhitzen des Verbundes auf eine Prozesstemperatur zwischen etwa 1025 bis 1083°C, z. B. auf ca. 1071 °C;
- Abkühlen auf Raumtemperatur.

Unter einem Aktivlot-Verfahren, z. B. zum Verbinden von Metallabschnitten oder Metallfolien, insbesondere auch von Kupferschichten oder Kupferfolien mit Keramikmaterial ist ein Verfahren zu verstehen, welches speziell auch zum Herstellen von Metall-Keramik-Substraten verwendet wird, wird bei einer Temperatur zwischen ca. 600-1000°C eine Verbindung zwischen einer Metallfolie, beispielsweise Kupferfolie, und einem Keramiksubstrat, beispielsweise Aluminiumnitrid-Keramik, unter Verwendung eines Hartlots hergestellt, welches zusätzlich zu einer Hauptkomponente wie Kupfer, Silber und/oder Gold auch ein Aktivmetall enthält. Dieses Aktivmetall, welches beispielsweise wenigstens ein Element der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlöt-Verbindung ist. Alternativ ist zur Anbindung auch ein Dickschichtverfahren vorstellbar.

Das heißisostatische Pressen ist beispielsweise aus der EP 3 080 055 B1 bekannt, auf deren Inhalt bezüglich des heißisostatischen Pressens hiermit explizit Bezug genommen wird.

Weitere Vorteile und Merkmale ergeben sich aus der nachfolgenden Beschreibung bevorzugter Ausführungsformen des erfindungsgemäßen Gegenstands mit Bezug auf die beigefügten Figuren. Einzelne Merkmale der einzelnen Ausführungsformen können dabei im Rahmen der Erfindung miteinander kombiniert werden.

Es zeigt:
- **Fig.1:**: schematisch ein Leistungsmodul gemäß einer ersten bevorzugten Ausführungsform der vorliegenden Erfindung,
- **Fig.2a** - **2e:**: schematisch ein Verfahren zur Herstellung eines Leistungsmoduls gemäß einer ersten bevorzugten Ausführungsform der vorliegenden Erfindung
- **Fig.3a bis 3h:**: schematisch ein Verfahren zur Herstellung eines Leistungsmoduls gemäß einer zweiten bevorzugten Ausführungsform der vorliegenden Erfindung
- **Fig.4a bis 4e:**: schematisch ein Verfahren zur Herstellung eines Leistungsmoduls gemäß einer dritten bevorzugten Ausführungsform der vorliegenden Erfindung und
- **Fig. 5a bis 5e**: schematisch ein Verfahren zur Herstellung eines Leistungsmoduls gemäß einer vierten bevorzugten Ausführungsform der vorliegenden Erfindung.

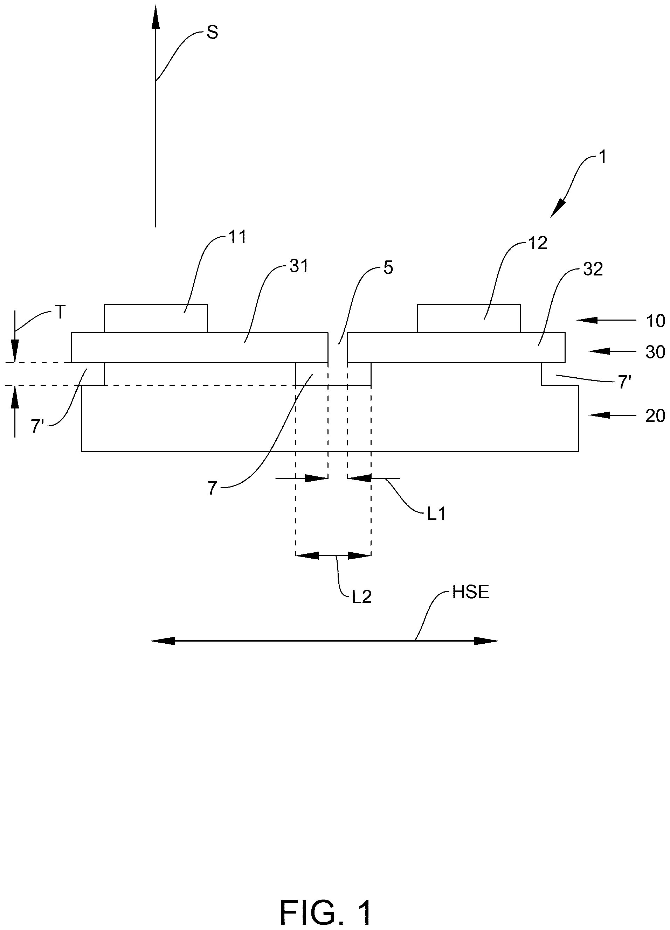

In **Figur 1** ist ein Leistungsmodul 1 gemäß einer ersten bevorzugten Ausführungsform der vorliegenden Erfindung schematisch dargestellt. Derartige Leistungsmodule 1 sind insbesondere dazu vorgesehen, als Träger für elektrische Bauteile 19 (nicht in Figur 1 dargestellt) zu dienen, die beispielsweise miteinander elektrisch verbunden sind und hierfür Leiterbahnen und/oder elektrische Anschlüsse benötigen. Vorzugsweise umfasst ein solches Leistungsmodul 1 eine primäre Metalllage 10, vorzugsweise mit einem ersten Metallabschnitt 11 und einem zweiten Metallabschnitt 12, wobei die primäre Metalllage 10 an eine Keramiklage 30 angebunden ist. Die Keramiklage 30 dient dabei insbesondere zur Isolation, d. h. elektrischen Isolation zwischen dem ersten Metallabschnitt 11 und dem zweiten Metallabschnitt 12 der primären Metalllage 10. Dabei erstrecken sich die primäre Metalllage 10 und/oder die Keramiklage 30 im Wesentlichen entlang einer Haupterstreckungsebene HSE und vorzugsweise sind die primäre Metalllage 10 und die Keramiklage 30 entlang einer senkrecht zur Haupterstreckungsebene HSE verlaufenden Stapelrichtung S übereinander angeordnet. Ferner ist es vorgesehen, dass in Stapelrichtung S gesehen an der Keramiklage 30 an der der primären Metalllage 10 gegenüberliegenden Seite eine sekundäre Metalllage 20 vorgesehen ist. Die sekundäre Metalllage 20 bildet vorzugsweise eine Rückseitenmetallisierung und/oder mindestens einen Teil eines Kühlkörpers aus. Durch die Ausbildung einer Rückseitenmetallisierung ist es in vorteilhafter Weise möglich, einem Durchbiegen der Keramiklage 30 entgegenzuwirken, indem durch die entsprechende Dimensionierung und Platzierung der Rückseitenmetallisierung thermomechanische Spannungen entgegengewirkt wird, die durch die primäre Metalllage 10 und deren Anbindung an die Keramiklage 30 verursacht werden. Allerdings verursacht dies ebenfalls Spannung, insbesondere im Grenzbereich zwischen der Keramiklage 30 einerseits und der primären Metalllage 10 und/oder der sekundären Metalllage 20 andererseits. Weiterhin ist es bevorzugt vorgesehen, dass die primäre Metalllage 10 und/oder die sekundäre Metalllage 20 über ein Direktmetalllageanbindungsverfahren, beispielsweise ein DCB- oder DAB-Verfahren, ein heißisostatisches Pressen oder mittels eines Aktivlötverfahrens an die Keramiklage 30 angebunden werden.

Weiterhin ist es in der Ausführungsform der Figur 1 bevorzugt vorgesehen, dass die Keramiklage 30 einen ersten Keramikabschnitt 31 und einen zweiten Keramikabschnitt 32 umfasst. Der erste Keramikabschnitt 31 ist dabei vom zweiten Keramikabschnitt 32 durch eine als Dehnungsfuge dienende Unterbrechung 5 getrennt. Durch die Verwendung einer Unterbrechung 5, die insbesondere als Dehnungsfuge zwischen dem ersten Keramikabschnitt 31 und dem zweiten Keramikabschnitt 32 dient, ist es in vorteilhafter Weise möglich, die thermomechanische Spannung bzw. die Spannung im gesamten Leistungsmodul 1 zu reduzieren. Dabei ist es vorzugsweise vorgesehen, dass das Leistungsmodul 1 unterhalb und oberhalb der Unterbrechung 5 einen Freiraum bzw. metallfreien Bereich aufweist, der insbesondere dazu beiträgt, eine Biegung des Leistungsmoduls 1, insbesondere der Keramiklage 30 zu reduzieren. In dem in Figur 1 dargestellten Ausführungsbeispiel wird der metallfreie Bereich unterhalb der Unterbrechung 5, d. h. auf der der sekundären Metalllage 20 zugewandten Seite, durch einen Rücksprung 7 in der zweiten Metalllage 20 hervorgerufen. Insbesondere ist es vorgesehen, dass die sekundäre Metalllage 20 zwecks der Ausbildung des metallfreien Bereichs an ihrer im gefertigten Zustand der Keramiklage 30 zugewandten Seite den Rücksprung 7 aufweist. Weiterhin ist es bevorzugt vorgesehen, dass die sekundäre Metalllage 20 an ihrem äußersten Rand einen weiteren Rücksprung 7' aufweist. Sowohl der Rücksprung 7 als auch der weitere Rücksprung 7' erweisen sich zudem als vorteilhaft, als dass sie einen elektrischen Überschlag zwischen der primären Metalllage 10 und der sekundären Metalllage 20 entgegenwirken. Dies gestattet beispielsweise, dass die primäre Metalllage 10 bzw. ein erster Metallabschnitt 11 und eine zweiter Metallabschnitt 12 der primären Metalllage 10 an einer Bauteilseite des Leistungsmoduls 1 möglichst frei, d. h. möglichst flächenoptimiert, platziert werden kann bzw. können, wodurch ein möglichst kompaktes Leistungsmodul 1 realisiert werden kann, ohne dass Gefahr besteht, dass ein elektrischer Überschlag die Funktionstüchtigkeit des Leistungsmoduls 1 beeinträchtigt oder sogar gefährdet.

Weiterhin ist es vorgesehen, dass ein Verhältnis einer parallel zu einer Haupterstreckungsebene bemessenen ersten Länge L1 der Unterbrechung 5 zwischen dem ersten Keramikabschnitt 31 und dem zweiten Keramikabschnitt 32 zu einer parallel dazu gemessenen zweiten Länge L2 des metallfreien Bereichs, insbesondere des Rücksprungs 7, unterhalb und/oder oberhalb der Unterbrechung 5 einen Wert zwischen 0,005 und 1, bevorzugt zwischen 0,01 und 0,5 und besonderes bevorzugt zwischen 0,02 und 0,2 annimmt..

Beispielsweise nimmt dabei eine erste Länge L1 einen Wert zwischen 10 µm und 1500 µm, bevorzugt zwischen 15 µm und 800 µm und besonders bevorzugt zwischen 20 und 60 µm.

Beispielsweise nimmt dabei eine zweite Länge L2 einen Wert zwischen 20 µm und 2000 µm, bevorzugt zwischen 100 µm und 1600 µm und besonders bevorzugt zwischen 200 und 1000 µm an.

Ferner weist der metallfreie Bereich unterhalb der Unterbrechung 5, d. h. auf der der sekundären Metalllage 20 zugewandten Seite, eine Tiefe T auf, die einen Wert zwischen 50 µm und 600 µm, bevorzugt zwischen 80 µm und 500 µm und besonders bevorzugt zwischen 200 µm und 400 µm annimmt.

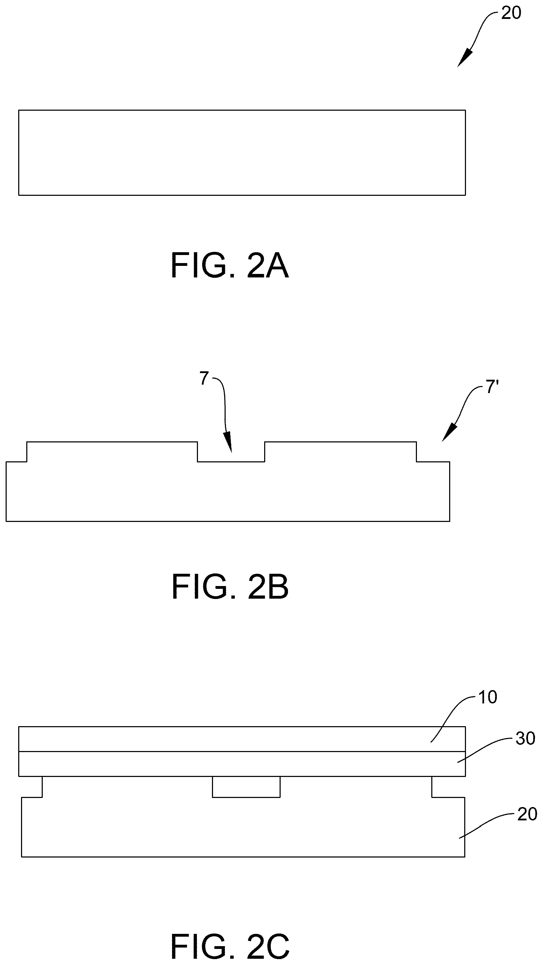

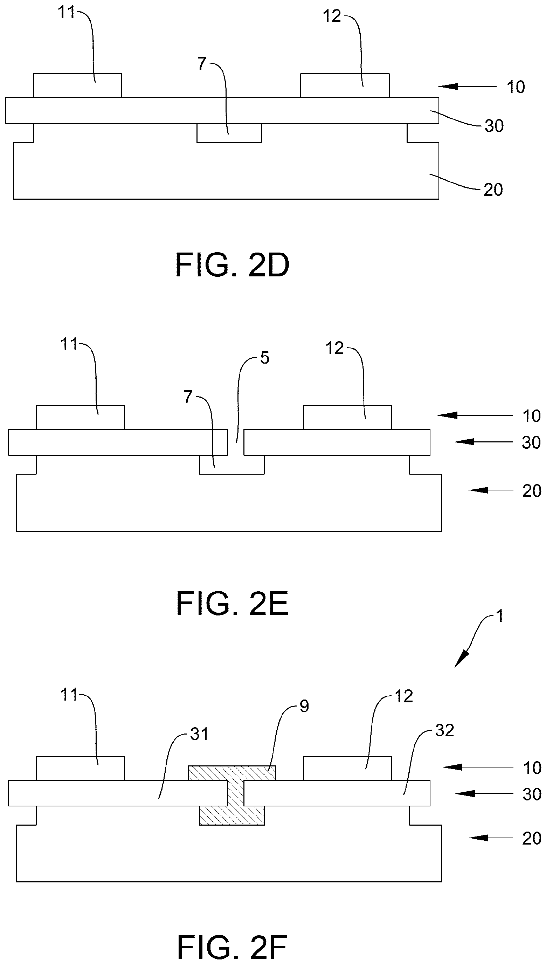

In den **Figuren 2a** - **2e** wird schematisch ein Verfahren zur Herstellung eines Leistungsmoduls 1 gemäß einer ersten beispielhaften Ausführungsform der vorliegenden Erfindung dargestellt. Dabei ist es zunächst vorgesehen, dass die sekundäre Metalllage 20 unstrukturiert bereitgestellt wird (siehe Figur 2a). Im nachfolgenden Schritt wird in die sekundäre Metalllage 20 mindestens ein Rücksprung 7 und/oder weitere Rücksprünge 7' eingelassen, insbesondere unter Verwendung eines mechanischen oder chemischen Verfahrens. Beispielsweise wird der mindestens eine Rücksprung 7 und/oder die weiteren Rücksprünge 7' mittels eines Ätzens, eines Laserns, eines Fräsens und/oder eines Prägens hergestellt (siehe Figur 2b).

Im Anschluss an die Strukturierung der sekundären Metalllage 20 werden die primäre Metalllage 10, die Keramiklage 30 und die sekundäre Metalllage 20 in Stapelrichtung S übereinander angeordnet, wobei die Keramiklage 30 zwischen der primären Metalllage 10 und der sekundären Metalllage 20 angeordnet ist. Insbesondere ist es dabei vorgesehen, dass in dieser Anordnung die sekundäre Metalllage 20 derart ausgerichtet ist, dass die Rücksprünge 7 an der Keramiklage 30 zugewandten Seite angeordnet sind. Anschließend wird beispielsweise durch ein Direktmetallanbindungsverfahren, ein heißisostatisches Pressen und/oder durch ein Aktivlötverfahren eine Anbindung zwischen der Keramiklage 30 und der primären Metalllage 10 und/oder der sekundären Metalllage 20 andererseits hergestellt (siehe Figur 2c). Nach dem Anbindungsverfahren wird vorzugsweise eine Strukturierung der primären Metalllage 10 vorgenommen, wodurch der erste Metallabschnitt 11 und der zweiter Metallabschnitt 12 gebildet werden (siehe Figur 2d). Beispielsweise wird hierzu mittels eines Ätzvorgangs und/oder mit einem mechanischen Bearbeiten, beispielsweise mit einem spanenden Bearbeiten, ein Teil der angebundenen primären Metalllage 10 wieder entfernt, wodurch sich eine Strukturierung an der Bauteilseite des Leistungsmoduls 1 ergibt. Insbesondere entspricht die Strukturierung der für das Leistungsmodul 1 später vorgesehenen Ausbildung der Leitungsbahnen und/oder Anschlüsse. Weiterhin ist es besonders bevorzugt vorgesehen, dass durch das Entfernen von bestimmten Bereichen der primären Metalllage 10 es erreicht wird, dass ein Bereich in Stapelrichtung S gesehen oberhalb des Rücksprungs 7 vom Metall der primären Metalllage 10 befreit wird.

Anschließend ist es vorgesehen, dass die Keramiklage 30 mit ihrer als Dehnungsfuge vorgesehenen Unterbrechung 5 ausgestattet wird. Beispielsweise wird hierzu die Keramiklage 30 mechanisch und/oder durch Laserlicht durchtrennt. Dabei erfolgt das Trennen des ersten Keramikabschnitts 31 von einem zweiten Keramikabschnitt 32 derart, dass keine Verbindung mehr zwischen dem ersten Keramikabschnitt 31 und dem zweiten Keramikabschnitt 32 realisiert ist bzw. ausgebildet ist, um so die Wirkung als Dehnungsfuge zu gewährleisten. Außerdem wird durch das Ausbilden der Unterbrechung 5 oberhalb des Rücksprungs 7 an der Außenseite der sekundären Metalllage 20 ein Leistungsmodul 1 hergestellt, bei dem oberhalb und unterhalb der Unterbrechung 5 ein metallfreier Bereich ausgebildet ist.

Weiterhin ist es vorstellbar, dass im Anschluss an das Ausbilden eines metallfreien Bereichs ober- und unterhalb der als Dehnungsfuge dienenden Unterbrechung 5 ein nicht-leitendes Material 9 in den Bereich der Unterbrechung 5 eingefügt bzw. eingelassen wird. Insbesondere ist es dabei vorgesehen, dass das nicht-leitende Material 9, beispielsweise ein Kunststoff umfassendes Material, sowohl die Unterbrechung 5 als auch den Rücksprung 7 der sekundären Metalllage 20 füllt und besonders bevorzugt gegenüber der Außenseite der Keramiklage 30 von der Keramiklage 30 absteht bzw. gegenüber der Keramiklage 30 in Stapelrichtung S vorsteht. Mittels des Füllmaterials, insbesondere des nicht-leitenden Materials 9, ist es möglich, die Isolation zwischen dem ersten Metallabschnitt 11 bzw. dem zweiten Metallabschnitt 12 der primären Metalllage 10 einerseits und der sekundären Metalllage 20 andererseits weiter zu unterstützen. Vorzugsweise ist das nicht-leitende Material 9 derart gewählt, dass sich deren Elastizität vorteilhaft in Bezug auf die Durchbiegung des Leistungsmoduls 1 auswirkt.

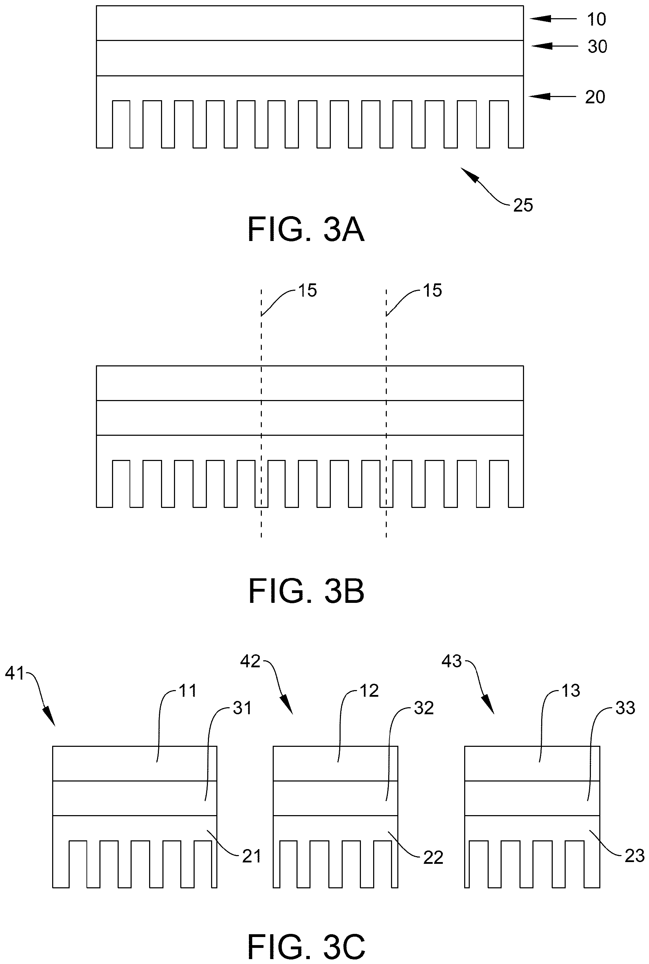

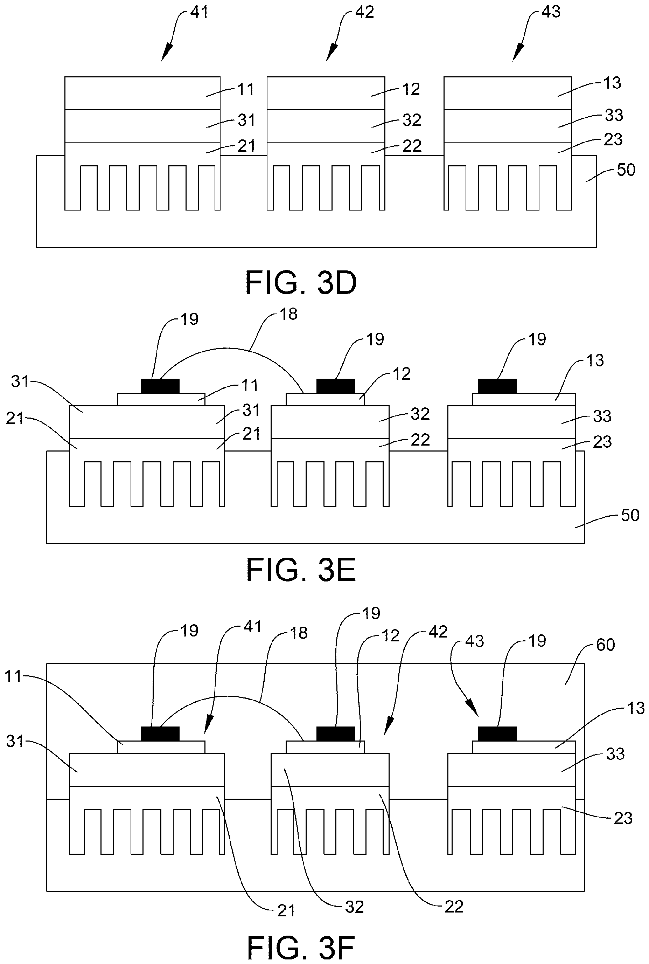

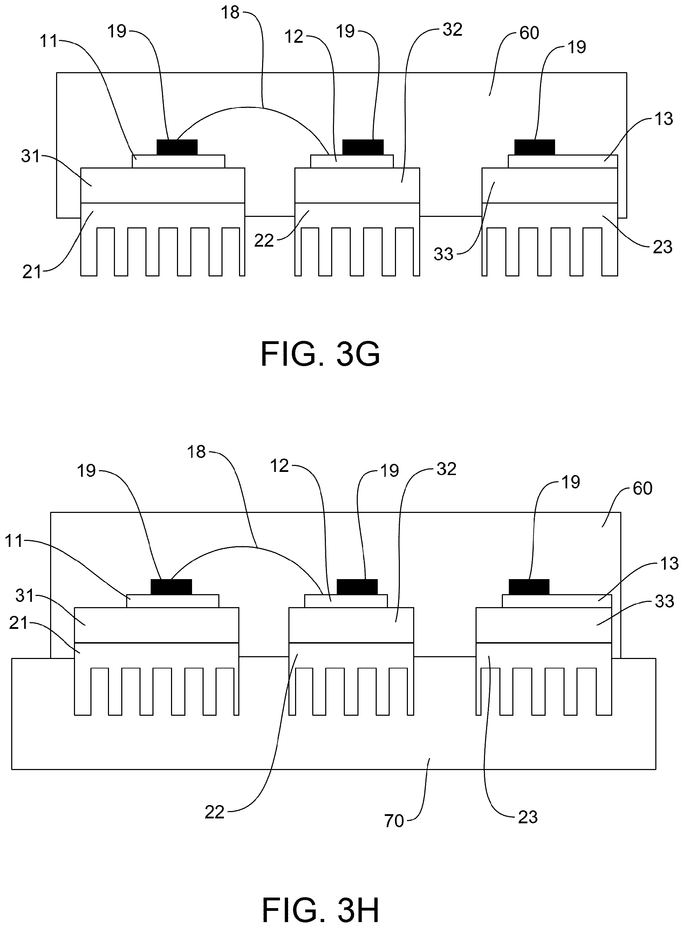

In den **Figuren 3a** - **3h** ist ein Verfahren zur Herstellung eines Leistungsmoduls 1 gemäß einer zweiten beispielhaften Ausführungsform der vorliegenden Erfindung dargestellt. Insbesondere ist es dabei vorgesehen, dass zu Beginn eine Anordnung aus der primären Metalllage 10, der Keramiklage 30 und der sekundären Metalllage 20 bereitgestellt wird, wobei die sich im Wesentlichen entlang der Haupterstreckungsebene HSE erstreckende primäre Metalllage 10, die sekundäre Metalllage 20 und die Keramiklage 30 übereinander angeordnet sind, wobei die Keramiklage 30 zwischen der primären Metalllage 10 und der sekundären Metalllage 20 angeordnet ist. Insbesondere ist es dabei vorgesehen, dass die sekundäre Metalllage 20 strukturiert ist, insbesondere eine Finnenstruktur 25 aufweist, die als Kühlelement bzw. Teil einer Kühlstruktur an der Unterseite der Keramiklage 30 vorgesehen ist. Insbesondere wird die Anordnung aus der primären Metalllage 10, der Keramiklage 30 und der sekundären Metalllage 20 in einem verbundenen Zustand bereitgestellt, d. h. im Vorfeld des Bereitstellens dieser Anordnung erfolgt eine Anbindung der primären Metalllage 10 und/oder der sekundären Metalllage 20 an die Keramiklage 30 mittels eines Anbindungsprozesses, wie einem Direktmetallanbindungsverfahren, einem heißisostatischen Pressen oder einem Aktivlötverfahren.

Weiterhin ist es vorgesehen, dass entlang von Trennlinien 15 die Anordnung aus der Figur 3a in einen ersten Verbund 41, einen zweiten Verbund 42 und einen dritten Verbund 43 unterteilt wird. Beispielsweise wird hierzu ein mechanisches Werkzeug, wie eine Säge und oder ein Fräskopf, Laserlicht und/oder ein Wasserstrahl verwendet, um die Anordnung aus Figur 3a in einen ersten Verbund 41, einen zweiten Verbund 42 und einen dritten Verbund 43 zu unterteilen. Dabei ist es insbesondere vorgesehen, dass der erste Verbund 41 eine erste Metallabschnitt 11 aus der primären Metalllage 10, einen ersten Keramikabschnitt 31 aus der Keramiklage 30 und einen ersten Metallabschnitt 21 der sekundären Metalllage 20 aufweist. Der zweite Verbund 42 weist eine zweite Metallabschnitt 12 aus der primären Metalllage 10, einen zweiten Keramikabschnitt 32 aus der Keramiklage und einen zweiten Metallabschnitt 22 in der sekundären Metalllage 20 auf. Der dritte Verbund 43 weist einen dritten Metallabschnitt 13 aus der primären Metalllage 10 und einen dritten Metallabschnitt 23 aus der sekundären Metalllage 20, sowie einen dritten Keramikabschnitt 33 aus der Keramiklage 30 auf. Nach dem Separieren bzw. Trennen des ersten Verbunds 41, des zweiten Verbunds 42 und des dritten Verbunds 43 voneinander, werden der erste Verbund 41, der zweite Verbund 42 und/oder der dritte Verbund 43 in einer Fixiermasse 50 und/oder einem Fixierelement angeordnet. Dabei ist es insbesondere vorgesehen, dass die Kühlstruktur, insbesondere die Finnenstruktur 25, des ersten Verbunds 41, des zweiten Verbunds 42 und des dritten Verbunds 43, in die Fixiermasse 50 und/oder das Fixierelement hineingesteckt werden, um den ersten Verbund 41, den zweiten Verbund 42 und den dritten Verbund 43 in der Fixiermasse 50 und/oder das Fixierelement zu fixieren.

Dabei sind der erste Verbund 41, der zweite Verbund 42 und der dritte Verbund 43 voneinander in einer parallel zur Haupterstreckungsebene HSE verlaufenden Richtung voneinander beabstandet. Weiterhin ist es vorgesehen, dass zumindest ein Abschnitt der sekundären Metalllage 20 aus der Fixiermasse 50 und/oder dem Fixierelement hervorsteht und bevorzugt, dass die Keramiklage 30 und die primären Metalllage 10 außerhalb der Fixiermasse 50 und/oder des Fixierelements angeordnet sind. Beispielsweise handelt es sich bei der Fixiermasse 50 um einen schnell härtenden oder einen aushärtbaren Kunststoff, der während des Einsetzens des ersten Verbunds 41, des zweiten Verbunds 42 und des dritten Verbunds 43 ein Eindringen des jeweiligen Verbunds bzw. der jeweiligen Finnenstruktur 25 zulässt und danach bei einem Aushärten derart erstarrt, dass der erste Verbund 41, der zweite Verbund 42 und der dritte Verbund 43 in der Fixiermasse 50 fixiert werden. Weiterhin ist es besonders bevorzugt vorgesehen, dass der erste Verbund 41, der zweite Verbund 42 und der dritte Verbund 43 mittels eines "Pick-and-Place" Roboters auf vorgesehene bzw. vorbestimmte Positionen in oder an der Fixiermasse 50 und/oder einem Fixierelement platziert werden. Nach dem Fixieren, insbesondere dem Aushärten der Fixiermasse 50, ist es besonders bevorzugt vorgesehen, dass elektrische Bauteile 19 und/oder weitere elektrische Verbindungen, wie beispielsweise Bonddrähte 18, montiert bzw. angelötet werden, wobei ein Bonddraht 18 beispielsweise den ersten Verbund 41 und den zweiten Verbund 42 miteinander elektrisch verbinden kann. Dabei ist es insbesondere vorgesehen, dass vor dem Bestücken des ersten Verbunds 41, des zweiten Verbunds 42 und des dritten Verbunds 43 eine Strukturierung in der primären Metalllage 10 erfolgt. Dabei ist es insbesondere vorgesehen, dass die primäre Metalllage 10 des ersten Verbunds 41, des zweiten Verbunds 42 und des dritten Verbunds 43 derart strukturiert wird, dass entsprechende erste Metallabschnitte 11, zweite Metallabschnitte 12 und dritte Metallabschnitte 13 zur Ausbildung von Leiterbahnen und Anschlüsse bereitgestellt werden.

Nach dem Bestücken und/oder dem elektrischen Verbinden einzelner Metallabschnitte 11, 12 und 13 der primären Metalllage 10 ist es bevorzugt vorgesehen, dass der erste Verbund 41, der zweite Verbund 42 und der dritte Verbund 43, insbesondere bestückt und miteinander elektrisch leitend verbunden, in eine Verkapselung 60 eingebettet werden. Dabei ist es insbesondere vorgesehen, dass die Fixiermasse 50 und/oder das Fixierelement während des Verkapselungsvorgangs die Finnenstruktur 25 bzw. die Finnen an der Unterseite des ersten Verbunds 41, des zweiten Verbunds 42 und/oder des dritten Verbunds 43 schützt (siehe Figur 3f). Beispielsweise handelt es sich bei der Verkapselung 60 um einen weiteren Kunststoff, der insbesondere derart ausgestaltet ist, dass er keine Zwischenräume bzw. Hohlräume zulässt. Weiterhin ist es vorstellbar, dass an der Oberseite der Verkapselung 60 eine weitere Metallisierungslage und/oder ein Anschluss vorgesehen ist, wobei bevorzugt Durchkontaktierungen durch die Verkapselung 60 vorgesehen sind, die eine elektrische Kontaktierung zulassen. Dadurch ist es möglich, von der Außenseite der Verkapselung 60 die elektrischen Bauteile 19 in der Verkapselung 60 elektrisch zu steuern.

Weiterhin ist es besonders bevorzugt vorgesehen, dass nach dem Vornehmen der Verkapselung 60 die Fixierungsmasse 50 und/oder das Fixierelement vom ersten Verbund 41, dem zweiten Verbund 42 und/oder dem dritten Verbund 43 wieder entfernt wird (siehe Figur 3g).

Dadurch ist es in vorteilhafter Weise möglich, die Anordnung aus dem ersten Verbund 41, dem zweiten Verbund 42 und dem dritten Verbund 43, eingelassen in die Verkapselung 60, mit einer Kühlflüssigkeitsführung 70 zu verbinden, mit der eine Kühlflüssigkeit an die Kühlstruktur, d. h. insbesondere an die Kühlfinnen, herangeführt werden kann bzw. dazu genutzt werden kann, die Finnenstruktur 25 mit der Kühlflüssigkeit zu umspülen, um so einen Wärmeabtransport über die Finnenstruktur 25 oder die Kühlstruktur zu gewährleisten.

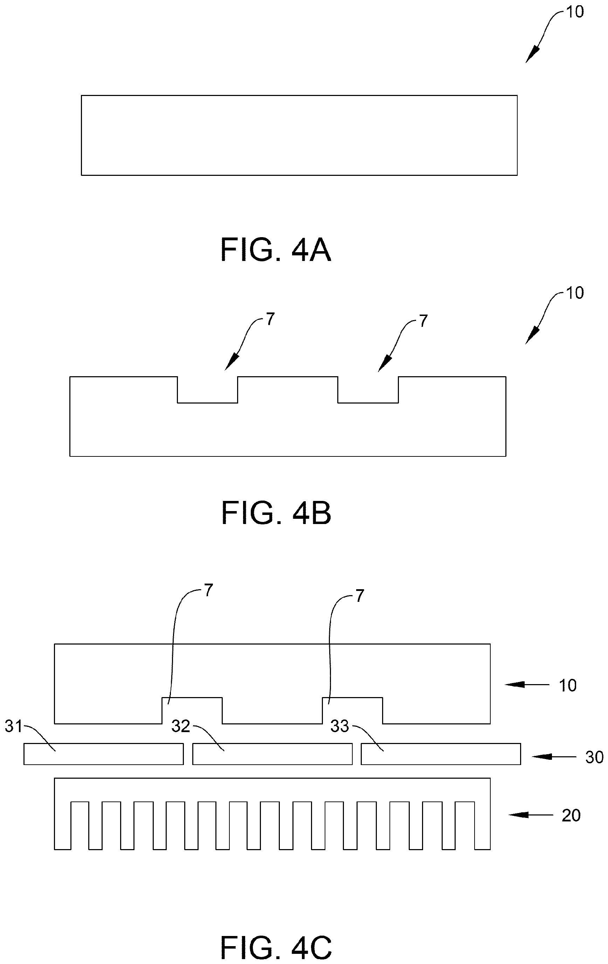

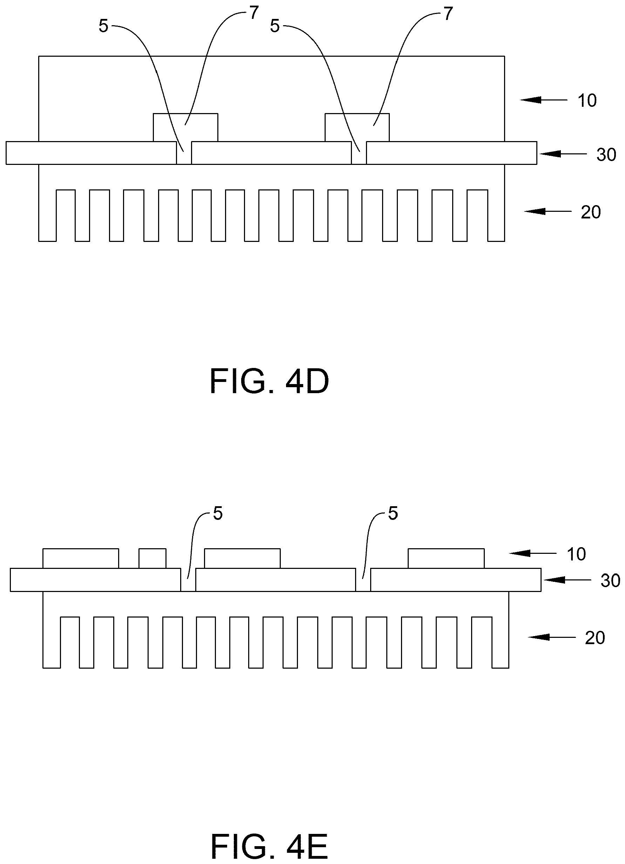

In den **Figuren 4a** - **4e** ist schematisch ein Verfahren zur Herstellung eines Leistungsmoduls 1 gemäß einer dritten bevorzugten Ausführungsform der vorliegenden Erfindung dargestellt. Insbesondere ist es in dem Ausführungsbeispiel der Figuren 4a - 4e vorgesehen, dass die primäre Metalllage 10 bereitgestellt wird (Figur 4a) und an seiner Außenseite strukturiert wird unter Ausbildung mindestens eines Rücksprungs 7 (siehe Figur 4b). Anschließend werden die primäre Metalllage 10, die sekundäre Metalllage 20 und die Keramiklage 30 in Stapelrichtung S übereinander angeordnet, wobei die primäre Metalllage 10 derart ausgerichtet ist, dass die im Vorfeld durch Strukturierung entstandenen Rücksprünge 7 oder der durch Strukturierung entstandene Rücksprung 7 der Keramiklage 30 zugewandt ist. Weiterhin ist es vorgesehen, dass die Keramiklage 30 zwischen der primären Metalllage 10 und der sekundären Metalllage 20 angeordnet ist. Im Gegensatz zu dem Ausführungsbeispiel aus den Figuren 2a - 2e wird die Keramiklage 30 in Form von bereits voneinander separierten bzw. voneinander getrennten Abschnitten, d. h. einem ersten Keramikabschnitt 31, einem zweiten Keramikabschnitt 32 und einem dritten Keramikabschnitt 33 bereitgestellt. Dabei werden der erste Keramikabschnitt 31, der zweite Keramikabschnitt 32 und der dritte Keramikabschnitt 33 derart ausgerichtet, dass zwischen dem ersten Keramikabschnitt 31 und dem zweiten Keramikabschnitt 32 bzw. zwischen dem zweiten Keramikabschnitt 32 und dem dritten Keramikabschnitt 33 eine Unterbrechung 5 gebildet wird, die insbesondere unterhalb des Rücksprungs 7 angeordnet ist, der durch die Strukturierung in der primären Metalllage 10 erzeugt wurde. Weiterhin ist es bevorzugt vorgesehen, dass die sekundäre Metalllage 20 eine Kühlstruktur, insbesondere in Gestalt einer Finnenstruktur 25, aufweist. Nach dem Anordnen und Ausrichten der einzelnen Abschnitte und Lagen, dargestellt in Figur 4c, ist es vorgesehen, dass eine Anbindung der primären Metalllage 10 und der sekundären Metalllage 20 an den ersten Keramikabschnitt 31, den zweiten Keramikabschnitt 32 und den dritten Keramikabschnitt 33 erfolgt (siehe Figur 4d). Dabei bilden sich Rücksprünge 7 bzw. Hohlbereiche bzw. Freibereiche oberhalb der Unterbrechung 5 in der primären Metalllage 10 aus. Abschließend wird die primäre Metalllage 10 strukturiert, beispielsweise durch Ätzen oder mechanisch, beispielsweise durch Fräsen oder Stanzen, derart, dass ein erster Metallabschnitt 11 und/oder ein zweiter Metallabschnitt 12 in der primären Metalllage 10 ausgebildet wird. Dabei können der erste Metallabschnitt 11 und der zweite Metallabschnitt 12 gemeinsam auf dem ersten Keramikabschnitt 31 angeordnet sein oder jeweils auf dem ersten Keramikabschnitt 31 und dem zweiten Keramikabschnitt 32. Weiterhin ist es vorgesehen, dass die primäre Metalllage 10 derart strukturiert wird, dass die Unterbrechungen 5 freigelegt werden. Durch die Anordnung der Rücksprünge 7 oberhalb der Unterbrechung 5 ist es in vorteilhafter Weise beispielsweise möglich durch ein Fräsen oder einen ähnlichen Vorgang auf einfache Weise die Unterbrechung 5 freizulegen, ohne Gefahr zu laufen, die sekundäre Metalllage 20 und/oder die Keramiklage 30 durch das Trennen oder Entfernen des Metalls von der primären Metalllage 10 zu gefährden.

Insbesondere ist es vorstellbar, dass in den Ausführungsbeispielen der Figuren 1, 2a bis 2e und 4a bis 4e die primäre Metalllage 10 und die sekundäre Metalllage 20 im Wesentlichen gleich dick sind (entgegen der graphischen Darstellung). Weiterhin ist es bevorzugt vorgesehen, dass die Anbindungsflächen zwischen der primären Metalllage 10 und dem Keramiklage 30 einerseits und die Anbindungsflächen zwischen der sekundären Metalllage 20 und dem Keramiklage 30 andererseits in Stapelrichtung S gesehen deckungsgleich zueinander angeordnet sind, wie es in der Figur 1 beispielhaft für den ersten Metallabschnitt 11 der primären Metalllage 10 und den darunter liegenden Abschnitt der Anbindungsfläche zwischen der sekundären Metalllage 20 und dem Keramiklage 30 vorgesehen ist.

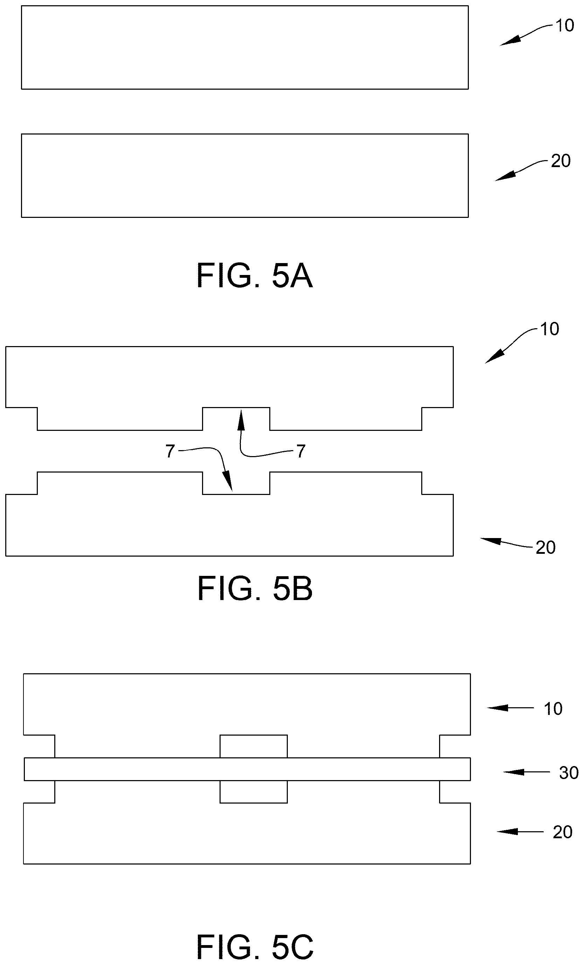

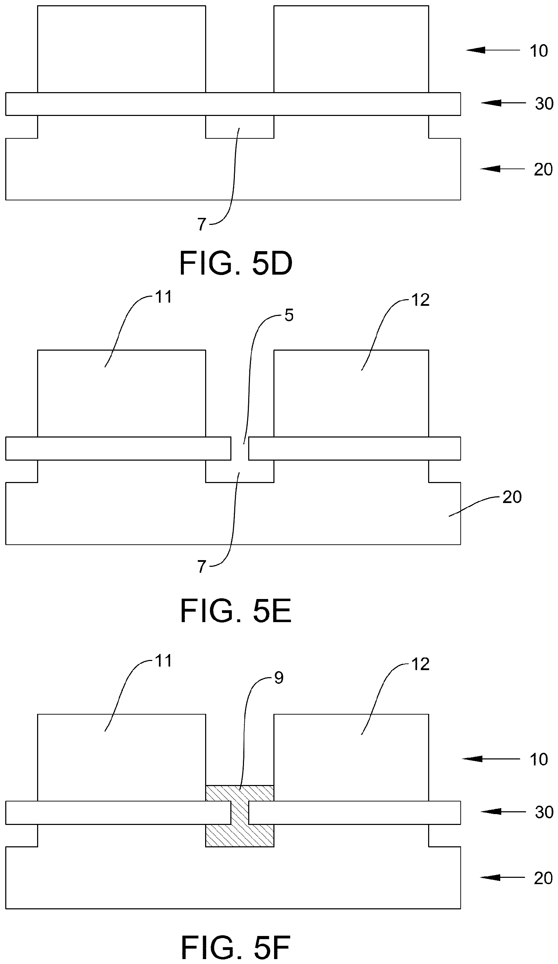

In den Figuren 5a bis 5e ist schematisch ein Verfahren zur Herstellung eines Leistungsmoduls 1 gemäß einer vierten bevorzugten Ausführungsform der vorliegenden Erfindung dargestellt. Dabei unterscheidet sich das Verfahren insbesondere von denjenigen aus den Figuren 2a bis 2e bzw. 4a bis 4e im Wesentlichen dahingehend, dass sowohl in die primäre Metalllage 10 als auch in die sekundäre Metalllage 20 jeweils Rücksprünge 7 eingelassen werden, die beim jeweiligen Anbinden an die Keramiklage 30 dem Keramiklage 30 zugewandt sind. Nach dem Entfernen von Metall aus der primären Metalllage 10, insbesondere oberhalb des Rücksprungs 7, zum Freilegen der Keramiklage 30 ist es bevorzugt vorgesehen, dass anschließend die Keramiklage 30 in Keramikabschnitte unterteilt wird. Weiterhin unterscheidet sich das Ausführungsbeispiel der Figuren 5a bis 5e dahingehend von den Ausführungsbeispielen der Figuren 1, 2a bis 2e und 4a bis 4e, dass das gefertigte Leistungsmodul 1 eine primäre Metalllage 10 und eine sekundäre Metalllage 20 aufweist, die im Wesentlichen gleich dick sind und deren Anbindungsflächen im Wesentlichen deckungsgleich zueinander verlaufen. Das in den Figuren 5a bis 5e dargestellte Verfahren lässt sich in vorteilhafter Weise ebenfalls auf die Ausführungsbeispiele aus den Figuren 2a bis 2e bzw. 2a bis 3e übertragen und andersrum. Weiterhin ist es vorstellbar, dass die sekundäre Metalllage 20 in den Figuren 5a bis 5e eine Finnenstruktur 25 oder Kühlstrukturierung aufweist.

### Bezugszeichenliste-.

- 1: Leistungsmodul
- 5: Unterbrechung
- 7: Rücksprung
- 7': weitere Rücksprung
- 9: nicht-leitendes Material
- 10: primäre Metalllage
- 11: erster Metallabschnitt der primären Metalllage
- 12: zweiter Metallabschnitt der primären Metalllage
- 13: dritter Metallabschnitt der primären Metalllage
- 15: Trennlinien
- 18: Bonddraht
- 19: Bauteil
- 20: sekundäre Metalllage
- 21: erster Metallabschnitt der sekundären Metalllage
- 22: zweiter Metallabschnitt der sekundären Metalllage
- 23: dritter Metallabschnitt der sekundären Metalllage
- 25: Finnenstruktur
- 30: Keramiklage
- 31: erster Keramikabschnitt
- 32: zweiter Keramikabschnitt
- 33: dritter Keramikabschnitt
- 41: erster Verbund
- 42: zweiter Verbund
- 43: dritter Verbund
- 50: Fixiermasse
- 60: Verkapslung
- 70: Kühlflüssigkeitsführung
- HSE: Haupterstreckungsebene
- S: Stapelrichtung
- L1: erste Länge
- L2: zweite Länge
- T: Tiefe

## Patentansprüche

1. Leistungsmodul (1) für elektrische Bauteile (19), umfassend:
- eine Keramiklage (30), eine primäre Metalllage (10) und eine sekundäre Metalllage (20), wobei die primäre Metalllage (10) und die sekundäre Metalllage (20) an der Keramiklage (30) an gegenüberliegenden Seiten angeordnet sind,
wobei die Keramiklage (30) einen ersten Keramikabschnitt (31) und einen vom ersten Keramikabschnitt (31) durch eine Unterbrechung (5) beabstandeten zweiten Keramikabschnitt (32) aufweist, und
wobei unterhalb und oberhalb der als Dehnungsfuge dienenden Unterbrechung (5) ein metallfreier Bereich ausgebildet ist, **dadurch gekennzeichnet, dass** die primäre Metalllage (10) und/oder die sekundäre Metalllage (20) auf einer der Unterbrechung (5) zugewandten Seite einen Rücksprung (7) zur Ausbildung des metallfreien Bereichs unterhalb der Keramiklage (30) aufweist.

2. Leistungsmodul (1) gemäß einem der vorhergehenden Ansprüche, wobei eine parallel zu einer Haupterstreckungsebene (HSE) bemessene erste Länge (L1) der Unterbrechung (5) zwischen dem ersten Keramikabschnitt (31) und dem zweiten Keramikabschnitt (32) einen Wert annimmt, der kleiner als 300 µm ist, bevorzugt kleiner als 200 µm und besonders bevorzugt kleiner als 100 µm.

3. Leistungsmodul (1) gemäß einem der vorhergehenden Ansprüche, wobei die sekundäre Metalllage (20) einstückig ausgebildet ist.

4. Leistungsmodul (1) gemäß einem der vorhergehenden Ansprüche, wobei der metallfreie Bereich unterhalb der Dehnungsfuge (5) in die sekundäre Metalllage (20) eingelassen ist.

5. Leistungsmodul (1) gemäß einem der vorhergehenden Ansprüche, wobei ein Verhältnis einer parallel zu einer Haupterstreckungsebene (HSE) bemessenen ersten Länge (L1) der Unterbrechung (5) zwischen dem ersten Keramikabschnitt (31) und dem zweiten Keramikabschnitt (32) zu einer parallel dazu gemessenen zweiten Länge (L2) des metallfreien Bereichs, insbesondere des Rücksprungs (7), unterhalb und/oder oberhalb der Unterbrechung (5) einen Wert zwischen 0,005 und 1, bevorzugt zwischen 0,01 und 0,5 und besonderes bevorzugt zwischen 0,02 und 0,2 annimmt.

6. Leistungsmodul (1) gemäß einem der vorhergehenden Ansprüche, wobei der metallfreie Bereich unterhalb der Unterbrechung (5) einen rechteckigen, runden und/oder dreieckigen Querschnitt in einer senkrecht zur Haupterstreckungsebene (HSE) verlaufenden Ebene aufweist.

7. Leistungsmodul (1) gemäß einem der vorhergehenden Ansprüche, wobei die Unterbrechung (5) mit einem nicht-leitenden Material (9) verfüllt ist.

8. Leistungsmodul (1) gemäß einem der vorhergehenden Ansprüche, wobei mehrere Dehnungsfugen vorgesehen sind, wobei ein Abstand zwischen zwei Dehnungsfugen geringer als 10 mm, bevorzugt kleiner als 5 mm und besonders bevorzugt kleiner als 2,5 mm ist und/oder sich mindestens zwei Dehnungsfugen schneiden..

9. Leistungsmodul (1) gemäß einem der vorhergehenden Ansprüche, wobei die Keramiklage (30) eine Dicke aufweist, die kleiner als 250 µm, bevorzugt kleiner als 200 µm und besonders bevorzugt kleiner als 150 µm ist.

10. Verfahren zur Herstellung eines Leistungsmoduls (1) gemäß einem der vorstehenden Ansprüche, umfassend
- Bereitstellen einer Keramiklage (30), einer primären Metalllage (10) und/oder einer sekundären Metalllage (20),
- Anbinden der primären Metalllage (10) und/oder der sekundären Metalllage (20) an die Keramiklage (30),
wobei zur Ausbildung einer Unterbrechung (5) in der Keramiklage (30) die Keramiklage (30)
- nach dem Anbinden aufgetrennt wird, beispielsweise mittels Laserlicht, Ätzen, Fräsen und/oder einem Wasserstrahl, oder
- zum Anbinden an die primären Metalllage (10) und/oder sekundären Metalllage (20) als erster Keramikabschnitt (31) und zweiter Keramikabschnitt vereinzelt bereitgestellt wird.

11. Verfahren gemäß Anspruch 10, wobei die primäre Metalllage (10) und/oder die sekundäre Metalllage (20) vor dem Anbinden an die Keramiklage (30) an einer Seite, die im gefertigten Zustand der Unterbrechung (5) zugewandt ist, mit mindestens einem Rücksprung (7) versehen wird, vorzugsweise unter Verwendung eines mechanischen Werkzeugs und/oder eines Lasers und/oder Ätzen.

12. Verfahren gemäß Anspruch 10 oder 11, wobei
- ein erster Verbund (41) aus einem ersten Keramikabschnitt (31) und einem ersten Metallabschnitt (11) der primären Metalllage (10) und einem ersten Metallabschnitt (21) der sekundären Metalllage (20) und
- ein zweiter Verbund (42) aus einem zweiten Keramikabschnitt (32) und einem zweiten Metallabschnitt (12) der primären Metalllage (10) und einem zweiten Metallabschnitt (22) der sekundären Metalllage (20) gebildet werden,
wobei der erste Verbund (41) und der zweite Verbund (42), insbesondere der erste Metallabschnitt (21) und der zweite Metallabschnitt (22) der sekundären Metalllage (20), in einer Fixiermasse (50) und/oder einem Fixierelement, vorzugsweise unter Verwendung eines "pick-and-place" Roboters, fixiert werden.

13. Verfahren gemäß einem der Ansprüche 10 bis 12, wobei ein Verkapseln mit einer Verkapselung (60) des Leistungsmoduls (1) vorgenommen wird.

14. Verfahren gemäß einem der Ansprüche 10 bis 13 wobei die primäre Metalllage (10) und/oder die sekundäre Metalllage (20) über ein Direktanbindungsverfahren, ein heißisostatisches Pressen oder ein Aktivlötverfahren an die Keramiklage (30) angebunden wird.

## Claims

1. A power module (1) for electrical components (19) comprising:
- a ceramic layer (30), a primary metal layer (10) and a secondary metal layer (20), wherein the primary metal layer (10) and the secondary metal layer (20) are arranged on the ceramic layer (30) on opposite sides,
wherein the ceramic layer (30) comprises a first ceramic portion (31) and a second ceramic portion (32) spaced from the first ceramic portion (31) by a discontinuity (5), and
wherein a metal-free region is formed below and above the discontinuity (5) serving as an expansion joint, **characterized in that** the primary metal layer (10) and/or the secondary metal layer (20) has a recess (7) on a side facing the discontinuity (5) for forming the metal-free region below the ceramic layer (30).

2. The power module (1) according to one of the preceding claims, wherein a first length (L1) of the discontinuity (5) between the first ceramic portion (31) and the second ceramic portion (32), dimensioned parallel to a main extension plane (HSE), has a value which is smaller than 300 µm, more preferably smaller than 200 µm and most preferably smaller than 100 µm.

3. The power module (1) according to any one of the preceding claims,
wherein the secondary metal layer (20) is integrally formed.

4. The power module (1) according to any one of the preceding claims,
wherein the metal-free region below the expansion joint (5) is embedded in the secondary metal layer (20).

5. The power module (1) according to any one of the preceding claims,
wherein a ratio of a first length (L1) of the discontinuity (5) between the first ceramic portion (31) and the second ceramic portion (32), dimensioned parallel to a main extension plane (HSE), to a second length (L2) of the metal-free region, in particular of the recess (7), measured parallel thereto below and/or above the discontinuity (5) has a value between 0.005 and 1, more preferably between 0.01 and 0.5 and most preferably between 0.02 and 0.2.

6. The power module (1) according to any one of the preceding claims,
wherein the metal-free region below the discontinuity (5) has a rectangular, circular and/or triangular cross-section in a plane running perpendicular to the main extension plane (HSE).

7. The power module (1) according to any one of the preceding claims,
wherein the discontinuity (5) is filled with a non-conductive material (9).

8. The power module (1) according to any one of the preceding claims,
wherein a plurality of expansion joints are provided, wherein a distance between two expansion joints is less than 10 mm, more preferably less than 5 mm and most preferably less than 2.5 mm and/or at least two expansion joints intersect.

9. The power module (1) according to any one of the preceding claims,
wherein the ceramic layer (30) has a thickness which is less than 250 µm, more preferably less than 200 µm and most preferably less than 150 µm.

10. A method for manufacturing a power module (1) according to any one of the preceding claims, comprising
- providing a ceramic layer (30), a primary metal layer (10) and/or a secondary metal layer (20),
- bonding the primary metal layer (10) and/or the secondary metal layer (20) to the ceramic layer (30),
wherein, in order to form a discontinuity (5) in the ceramic layer (30), the ceramic layer (30)
- is separated after bonding, for example by means of laser light, etching, milling and/or a jet of water, or
- is provided singulated as a first ceramic portion (31) and a second ceramic portion for bonding to the primary metal layer (10) and/or secondary metal layer (20).

11. The method according to claim 10, wherein the primary metal layer (10) and/or the secondary metal layer (20) is provided with at least one recess (7) before bonding to the ceramic layer (30) on a side which faces the discontinuity (5) in the manufactured state, preferably with the use of a mechanical tool and/or a laser and/or etching.

12. The method according to claim 10 or 11, wherein
- a first compound (41) is formed from a first ceramic portion (31) and a first metal portion (11) of the primary metal layer (10) and a first metal portion (21) of the secondary metal layer (20) and
- a second compound (42) is formed from a second ceramic portion (32) and a second metal portion (12) of the primary metal layer (10) and a second metal portion (22) of the secondary metal layer (20),
wherein the first compound (41) and the second compound (42), in particular the first metal portion (21) and the second metal portion (22) of the secondary metal layer (20), are fixed in a fixing mass (50) and/or a fixing element, preferably with the use of a "pick-and-place" robot.

13. The method according to any one of claims 10 to 12, wherein an encapsulation is performed with an encapsulation (60) of the power module (1).

14. The method according to any one of claims 10 to 13, wherein the primary metal layer (10) and/or the secondary metal layer (20) is bonded to the ceramic layer (30) via a direct bonding process, a hot isostatic pressing process or an active soldering process.

## Revendications

1. Module de puissance (1) pour composants électriques (19), comprenant :
- une couche céramique (30), une couche métallique primaire (10) et une couche métallique secondaire (20), la couche métallique primaire (10) et la couche métallique secondaire (20) étant disposées sur la couche céramique (30) sur des faces opposées,
la couche céramique (30) présentant une première portion céramique (31) et une deuxième portion céramique (32) espacée de la première portion céramique (31) par une interruption (5), et
une zone exempte de métal étant formée au-dessous et au-dessus de l'interruption (5) servant de joint de dilatation,
**caractérisé en ce que**
la couche métallique primaire (10) et/ou la couche métallique secondaire (20) présente, sur une face tournée vers l'interruption (5), un retrait (7) destiné à former une zone exempte de métal au-dessous de la couche céramique (30).

2. Module de puissance (1) selon la revendication précédente,
dans lequel une première longueur (L1), mesurée parallèlement à un plan d'extension principale (HSE), de l'interruption (5) entre la première portion céramique (31) et la deuxième portion céramique (32) prend une valeur inférieure à 300 µm, de préférence inférieure à 200 µm et de manière particulièrement préférée inférieure à 100 µm.

3. Module de puissance (1) selon l'une des revendications précédentes,
dans lequel la couche métallique secondaire (20) est formée d'un seul tenant.

4. Module de puissance (1) selon l'une des revendications précédentes,
dans lequel la zone exempte de métal au-dessous du joint de dilatation (5) est encastrée dans la couche métallique secondaire (20).

5. Module de puissance (1) selon l'une des revendications précédentes,
dans lequel un rapport d'une première longueur (L1), mesurée parallèlement à un plan d'extension principale (HSE), de l'interruption (5) entre la première portion céramique (31) et la deuxième portion céramique (32), sur une deuxième longueur (L2), mesurée parallèlement à la première, de la zone exempte de métal, en particulier du retrait (7), au-dessous et/ou au-dessus de l'interruption (5), prend une valeur comprise entre 0,005 et 1, de préférence entre 0,01 et 0,5 et de manière particulièrement préférée entre 0,02 et 0,2.

6. Module de puissance (1) selon l'une des revendications précédentes,
dans lequel la zone exempte de métal au-dessous de l'interruption (5) présente une section transversale rectangulaire, circulaire et/ou triangulaire dans un plan perpendiculaire au plan d'extension principale (HSE).

7. Module de puissance (1) selon l'une des revendications précédentes,
dans lequel l'interruption (5) est remplie d'un matériau non conducteur (9).

8. Module de puissance (1) selon l'une des revendications précédentes,
dans lequel plusieurs joints de dilatation sont prévus, la distance entre deux joints de dilatation étant inférieure à 10 mm, de préférence inférieure à 5 mm et de manière particulièrement préférée inférieure à 2,5 mm,
et/ou au moins deux joints de dilatation se coupent.

9. Module de puissance (1) selon l'une des revendications précédentes,
dans lequel la couche céramique (30) présente une épaisseur inférieure à 250 µm, de préférence inférieure à 200 µm et de manière particulièrement préférée inférieure à 150 µm.

10. Procédé de fabrication d'un module de puissance (1) selon l'une des revendications précédentes, consistant à
- fournir une couche céramique (30), une couche métallique primaire (10) et/ou une couche métallique secondaire (20),
- lier la couche métallique primaire (10) et/ou de la couche métallique secondaire (20) à la couche céramique (30),
dans lequel, pour former une interruption (5) dans la couche céramique (30), la couche céramique (30)
- est séparée après la liaison, par exemple au moyen d'une lumière laser, par attaque chimique, par fraisage et/ou au moyen d'un jet d'eau, ou
- est fournie de façon individualisée sous forme de première portion céramique (31) et de deuxième portion céramique, pour la liaison à la couche métallique primaire (10) et/ou à la couche métallique secondaire (20).

11. Procédé selon la revendication 10,
dans lequel la couche métallique primaire (10) et/ou la couche métallique secondaire (20), avant d'être liée à la couche céramique (30), est pourvue d'au moins un retrait (7) sur une face qui, à l'état fabriqué, est tournée vers l'interruption (5), de préférence à l'aide d'un outil mécanique et/ou d'un laser et/ou par attaque chimique.

12. Procédé selon la revendication 10 ou 11,
dans lequel
- un premier composite (41) est formé à partir d'une première portion céramique (31) et d'une première portion métallique (11) de la couche métallique primaire (10) et d'une première portion métallique (21) de la couche métallique secondaire (20), et
- un deuxième composite (42) est formé à partir d'une deuxième portion céramique (32) et d'une deuxième portion métallique (12) de la couche métallique primaire (10) et d'une deuxième portion métallique (22) de la couche métallique secondaire (20),
dans lequel
le premier composite (41) et le deuxième composite (42), en particulier la première portion métallique (21) et la deuxième portion métallique (22) de la couche métallique secondaire (20), sont fixés dans une masse de fixation (50) et/ou dans un élément de fixation, de préférence à l'aide d'un robot de prise et de pose, dit "pick-and-place".

13. Procédé selon l'une des revendications 10 à 12,
dans lequel le module de puissance (1) est encapsulé avec un encapsulage (60).

14. Procédé selon l'une des revendications 10 à 13,
dans lequel la couche métallique primaire (10) et/ou la couche métallique secondaire (20) sont liées à la couche céramique (30) par un procédé de liaison directe, un procédé de pressage isostatique à chaud ou un procédé de brasage actif.
